# EUROPEAN PATENT APPLICATION

(11) **EP 3 886 161 A1**
(43) Date of publication of application: **29.09.2021**
(21) Application number: 19887570.0
(22) Date of filing: 19.11.2019
(51) Int. Cl.: H01L 25/18, H01L 25/04, H05K 3/46

(54) **SEMICONDUCTOR PACKAGE SUBSTRATE AND METHOD FOR PRODUCING SAME**

(30) Priority: 20.11.2018 JP 2018217636
(71) Applicant: Toppan Printing Co., Ltd., Tokyo 110-0016 (JP)
(72) Inventor: TAKAGI, Fusao, Tokyo 110-0016 (JP)
(74) Representative: Plasseraud IP
(86) International application number: PCT/JP2019/045274
(87) International publication number: WO 2020/105633

(57) **Abstract**

A semiconductor packaging substrate includes a first major surface on which a semiconductor device is mounted and a second major surface on which an external connection terminal for electrical connection to a printed wiring board is formed. One or more first wiring layers are formed on the first major surface side. The first wiring layer includes a first insulating resin layer (110) and a first conductor circuit layer (130), and the first conductor circuit layer includes via hole portions (141) and wiring portions (142). A seed metal layer is formed on three surfaces in which the first insulating resin layer and the wiring portion of the first conductor circuit layer are grounded, and one or more second wiring layers are formed on the second major surface side. The second wiring layer includes a second insulating resin layer (170) and a second conductor circuit layer of via hole portions (191) and wiring portions (190), and a seed metal layer is formed on only one surface in which the wiring portion of the second conductor circuit layer and the second insulating resin layer are grounded.

## Description

### [Technical Field]

The present invention relates to a semiconductor packaging substrate on which a semiconductor device is mounted and a method for manufacturing the semiconductor packaging substrate, and in particular relates to miniaturization of a circuit, improvement in planarity of a device connection surface, improvement in dimensional stability, improvement in connection reliability, and cost reduction.

### [Background Art]

In order to deal with miniaturization of semiconductor devices, an increase in the degree of integration of the semiconductor devices, and improvement of functions in the semiconductor devices, effort has been made to put to practical use semiconductor devices that are thinner and three-dimensionally laminated together in a height direction using through silicon vias (TSVs). A TSV is an electrode formed to penetrate a silicon substrate of a semiconductor device and allows laminated semiconductor devices to be electrically connected at the shortest distance, enabling a reduction in transmission loss and in power consumption. Since the number of layers is increased in the height direction, it is possible to increase the functionality and capacity without increasing the mounting area, which is an effective means for improving miniaturization, integration, and functionality of semiconductor devices.

The miniaturization and functional improvement for semiconductor devices based on three-dimensional lamination are only achieved in DRAMs in which similar semiconductor devices are three-dimensionally laminated. This is because lamination of different semiconductor devices (for example, a memory, a logic devices, and the like) leads to design constraints such as providing unified standards for TSVs. In the case where a defect occurs after a plurality of different semiconductor devices are assembled in a plurality of layers, it is difficult to determine whether the defect results from device manufacturing or assembly, leading to a problem in terms of quality assurance and production responsibility. Furthermore, there is a problem in which if semiconductor devices, which generate a large amount of heat, are three-dimensionally laminated, a heat dissipation problem fails to be solved.

Thus, a dominant technique for improving the functions of semiconductor devices is a so-called 2.5D package in which three-dimensionally laminated DRAMs and semiconductor devices such as logic devices are integrated together on a silicon interposer and in which the silicon interposer equipped with a plurality of different semiconductor devices is mounted on a semiconductor packaging substrate. In the 2.5D package, signal connections between a plurality of semiconductor devices are established by a microcircuit on the silicon interposer, and thus the silicon interposer as a whole can be considered as one SOC (system on chip) in which functions are integrated.

The silicon interposer is manufactured using a 300-mm silicon wafer. On a front surface of the silicon interposer on which semiconductor devices are mounted, a fine multilayer wiring layer with a pitch of submicrons to several microns is provided that is manufactured using a semiconductor process, whereas on a back surface of the silicon interposer, connection terminals and an electric circuit for connection to the semiconductor packaging substrate are provided. The front circuit and the back circuit are electrically connected by TSVs penetrating the silicon substrate.

The silicon interposer requires formation of TSVs. This requires dry etching of a silicon substrate to form through holes having a high aspect ratio, and then the through hole is filled by electrolytic copper plating. Therefore, high manufacturing costs are required. Thus, the silicon interposer is limited to application in servers, high-end PCs, high-end graphics, and the like, which require high performance rather than low costs, which is an obstacle to widespread.

In the 2.5D package, the silicon interposer needs to be interposed between the semiconductor packaging substrate and the semiconductor device, leading to a need for a large number of members and mountings. This disadvantageously leads to high costs and low efficiency.

Furthermore, a square silicon interposer is manufactured from a circular 300-mm wafer, and thus has low patterning efficiency and requires high costs compared to an organic semiconductor packaging substrate manufactured from a large square panel of approximately 600×500 mm. Moreover, with recently improved functionality of semiconductor devices, semiconductor devices such as GPUs, CPUs, and FPGAs tend to increase in size year by year due to an increased number of transistors mounted. There has also been an increasing demand for an increase in size of the silicon interposer accommodating the transistors. There has been an increasing demand for a more inexpensive and efficient new packaging technology replacing the silicon interposer.

As a candidate for the new packaging technique, an organic semiconductor packaging substrate (so-called 2.1D interposer also referred to as 2.1D semiconductor packaging substrate) has been developed. An organic semiconductor packaging substrate eliminates the need for the silicon interposer by forming multilayer wiring layers on a device mounting surface side of a known organic semiconductor packaging substrate such that multilayer wiring layers have a wiring density close to the wiring density of the silicon interposer.

A technical problem of the 2.1D semiconductor packaging substrate is forming multiple layers of thin-layer fine wiring close to the silicon interposer, on the semiconductor device mounting surface. This is because the 2.1D semiconductor packaging substrate, involving electrical connections of a plurality of semiconductor devices, significantly increases the number of signal lines compared to a known semiconductor packaging substrate on which only one semiconductor device is mounted. Even a rule for the smallest pattern width and layer thickness (indicative of the sum of a conduction layer thickness and an insulating resin layer thickness) in a known method for manufacturing a semiconductor packaging substrate specifies a line & space (hereinafter referred to as L/S) L/S = 10/10 µm and approximately 20 µm per layer. However, the 2.1D semiconductor packaging substrate requires thin-layer fine wiring with at least L/S = 5/5 µm to 2/2 µm and a wiring layer thickness per layer of 3 to 10 µm.

Now, a general method for manufacturing a semiconductor packaging substrate will briefly be described.

A multilayer circuit in the semiconductor packaging substrate is manufactured by so-called build-up technique including repetition of formation of an interlayer insulating resin and formation of a circuit layer.
1) First, a known method for manufacturing a printed wiring board is used to provide a core substrate provided with two or more wiring circuit layers. Copper wiring having a height of 10 µm or more and 50 µm or less is formed on a front surface of the core substrate. The core substrate may be a multilayer board including an interior circuit. The front surface of the core substrate has surface asperities of approximately from 10 µm to 50 µm depending on the height of a circuit formed, or warpage or waviness caused by an inner layer wiring density difference, or variance in planarity. Subsequently, an interlayer insulating resin film including a silica filer and a thermosetting resin is laminated on both the front and back surfaces of the core substrate by vacuum pressing and then thermally cured to form an interlayer insulating resin layer.
2) A laser processing machine is used to form via holes (holes through which multilayer circuits are electrically connected) in the interlayer insulating resin on both the front and back surfaces formed on the core substrate.
3)Smears at via bottoms (on via receiving copper pads formed on the core substrate) and via peripheries which occurs during laser processing are immersed and etched away in a hot alkaline permanganic acid solution.
4) Electroless copper plating is applied onto the insulating resin to make the surface of the resin and the inside of the vias conductive.
5) Dry film resist is laminated on the front and back surfaces of the substrate by thermocompression bonding, and during the subsequent exposure and development processing, a resist pattern that is opposite to the pattern of the circuit is formed.
6) By applying electrolytic copper plating using an electroless plating layer as a conductive layer, wiring and via holes are plated and filled with copper to form a circuit.
7) Unnecessary portions of the resist are peeled off.
8) Unnecessary portions of the electroless plating layer resulting from the peeling of the resist are etched away to form a wiring circuit.

The circuit forming method in steps 1) to 8) described above is referred to as a semi-additive technique, and allows a semiconductor packaging substrate to be manufactured but necessarily includes warpage or waviness of the substrate or variance in planarity of the surface within the range from several dozen µm to several mm due to the planarity of the core substrate, a difference in wiring density between formed multilayer wiring layers, or residual stress resulting from combination of different materials.

PTL 1 describes a conventional technique for the present object, and is an invention in which CMP is used to polish and planarize one layer of wiring in the foremost layer of a semiconductor element mounting surface of a semiconductor packaging substrate manufactured by a normal process. However, the semiconductor packaging substrate includes warpage, waviness, or the variance in planarity which occurs within the range of at least from several dozen µm to several mm. To form a fine wiring layer, lithography using a projective exposure apparatus with a high numerical aperture (NA) is required. If lithography is used, a depth of focus becomes 10 µm or less, which is narrow. Accordingly, it is difficult in principle to form fine wiring on a substrate with significant warpage, waviness, or great variance in planarity. Even in the case where one layer of wiring on the semiconductor element mounting surface is planarized by CMP as in PTL 1, it is exceedingly difficult to absorb, using CMP, the warpage or waviness or the variance in planarity all over the panel. Even in the case where CMP is implemented, manufacturing at a high yield is impossible. As described above, in the case where the conventional technique is used to produce fine multilayer wiring layers later on the semiconductor packaging substrate, manufacturing at a high yield is difficult because of difficulty in controlling planarity. Production of fine wiring requires a substrate on which planarity is ensured.

Furthermore, the semi-additive technique for a region with L/S = 2 to 5 µm has difficulty in uniformly controlling undercuts due to a panel in-plane variance during a seed etching step. Moreover, peeling of wiring is often caused by weakening of adhesion between the wiring and the insulating resin, and physical stress caused by transport rollers, leading to difficulty manufacturing at a high yield. Furthermore, in the case where a fine wiring layer is formed by the semi-additive technique, the wiring layer is formed by a pattern copper plating method, but the pattern copper plating necessarily produces current concentration portions depending on the wiring pattern density. Thus, during the plating step, forming a uniform wiring height all over the surface is difficult. Consequently, an impedance matching problem and further a locally reduced thickness of an insulating layer between circuit layers leads to difficulty in ensuring insulation reliability.

PTL 2 discloses small pieces of fine wiring manufactured by a semiconductor process which are embedded and mounted to a semiconductor packaging substrate. A semiconductor device mounted on a 2.1D semiconductor packaging substrate is fine and has a connection terminal pitch of 40 µm to 60 µm. The accuracy of the positions where the small pieces of the fine wiring layer are mounted needs to be at least ±5 µm or less. Furthermore, in the present application, a plurality of DRAMs are mounted for one logic semiconductor device. Thus, it is exceedingly difficult to mount these devices with a high positional accuracy to allow all the devices to be simultaneously connected. Additionally, even in the case where the small pieces of the fine wiring layer are embedded in an adhesive layer or an insulating resin for fixation, disadvantageously the small pieces may migrate during formation of a resin layer corresponding to a postprocess or may become misaligned during a thermosetting step. Consequently, the 2.1D semiconductor packaging substrate scheme, which is simpler and has a higher yield, has been desired.

Characteristics required for the 2.1D semiconductor packaging substrate are not limited to a reduced size, but also high connection reliability is required for the 2.1D semiconductor packaging substrate. Major factors for the connection reliability include rigidity of the semiconductor packaging substrate and difference in thermal expansion coefficient. In general, photosensitive insulating resins are advantageous for forming fine wiring. However, due to a need for thickness reduction and possibility of degradation of lithography characteristics, providing a filler or a glass fiber cloth in the resin is difficult, leading to high thermal expansion coefficient and low elastic modulus. Even in the case where the photosensitive insulating resin is used, a more reliable 2.1D semiconductor packaging substrate is desired that includes a combination of the photosensitive insulating resin and the rigid material.

In PTL 3, a semiconductor device is disclosed. The semiconductor device is provided with a wiring layer by forming thin multilayer wiring layers on one surface of a glass support body, then integrating the thin multilayer wiring layers with the semiconductor device, peeling off the support body, and dividing the semiconductor device into pieces. In PTL 3, electrical inspection is not possible until the wiring layer and the semiconductor device are integrated. In other words, electrical inspection is essentially not possible with only the thin multilayer wiring layers formed on the support body, the electrical inspection being conducted by simultaneously applying probes to external connection terminals formed on a back surface of the wiring layer. This leads to difficulty in detecting defects in the wiring layer before assembling to the semiconductor device. In an expensive multichip package in which, for example, a plurality of three-dimensional laminated DRAMs and a plurality of logic devices are mounted, any defects in the wiring layer leads to disposal of conforming devices. Thus, this scheme is not realistic.

Consequently, for the 2.1D semiconductor packaging substrate, even a semiconductor packaging substrate having a thin-layer fine wiring layer is required to provide reliable quality.

### [Citation List]

### [Patent Literature]

[PTL 1] JP 5558623 B
[PTL 2] JP 2015-50315 A
[PTL 3] JP 2007-242888 A

### [Summary of the Invention]

### [Technical Problem]

The present invention has been developed to solve the above-described problems, and an object of the present invention is to provide a semiconductor packaging substrate enabling high-yield, efficient manufacturing of even a semiconductor packaging substrate including a planar thin-layer fine wiring layer eliminating the need for a silicon interposer, the semiconductor packaging substrate having sufficient rigidity and providing high connection reliability, favorable transmission characteristics, and high insulation reliability, and also to provide a method for manufacturing the semiconductor packaging substrate.

### [Solution to Problem]

A semiconductor packaging substrate according to the present invention includes a first major surface on which a semiconductor device is mounted, and a second major surface on which an external connection terminal for electrical connection to a printed wiring board is formed, wherein at least one first wiring layer is formed on a first major surface side, the first wiring layer includes a first insulating resin layer and a first conductor circuit layer, the first conductor circuit layer includes a via hole portion and a wiring portion, a seed metal layer is formed on three surfaces in which the first insulating resin layer, and the wiring portion of the first conductor circuit layer are grounded, at least one second wiring layer is provided on the second major surface side, the second wiring layer includes a second insulating resin layer and a second conductor circuit layer including a via hole portion and a wiring portion, and a seed metal layer is formed on only one surface in which the wiring portion of the second conductor circuit layer and the second insulating resin layer are grounded.

A method for manufacturing a semiconductor packaging substrate according to the present invention includes the steps of forming, on a glass support body, a first conductor circuit layer on a first insulating resin layer of a photosensitive insulating resin to form at least one wiring layer, forming, on the first wiring layer, a second insulating resin layer including a non-photosensitive insulating resin including a glass fiber cloth or an inorganic filler and forming, on the second insulating resin layer, a second conductor circuit layer including a via hole portion and a wiring portion using a semi-additive technique to form at least one second wiring layer, and peeling a laminate of the first wiring layer and the second wiring layer from the glass support body.

### [Advantageous Effects of the Invention]

The semiconductor packaging substrate and the method for manufacturing the semiconductor packaging substrate according to the present invention eliminate the need for a silicon interposer. Even a semiconductor packaging substrate having a planar thin-layer fine wiring layer can be efficiently manufactured at a high yield, and the semiconductor packaging substrate has sufficient rigidity and provides high connection reliability, favorable transmission characteristics, and high insulation reliability.

### [Brief Description of the Drawing]

Fig.1 is a cross-sectional view of a semiconductor packaging substrate according to the present invention.
Fig.2 is a cross-sectional view of a semiconductor device using the semiconductor packaging substrate according to the present invention.
Fig. 3A is a diagram illustrating a glass support body.
Fig. 3B is a cross-sectional view illustrating a state in which a photosensitive insulating resin layer is provided on the glass support body.
Fig. 3C is a cross-sectional view illustrating a state of formation of an external connection pattern on the photosensitive insulating resin layer.
Fig. 3D is an enlarged detailed diagram of an enclosed region A-A' shown in Fig. 3C.
Fig. 3E is a cross-sectional view illustrating a state in which an electrolytic copper plating layer is formed.
Fig. 3F is an enlarged detailed diagram of an enclosed region A-A' shown in Fig. 3E.
Fig. 4A is a cross-sectional view illustrating an external connection terminal layer for a semiconductor device formed by planarization polishing.
Fig. 4B is an enlarged detailed diagram of an enclosed region A-A' shown in Fig. 4A.
Fig. 4C is a cross-sectional view illustrating a state in which the photosensitive insulating resin layer is formed.
Fig. 4D is a cross-sectional view illustrating a state in which via holes and wiring trenches are formed in the photosensitive insulating resin layer.
Fig. 4E is an enlarged detailed diagram of an enclosed region A-A' in Fig. 4D.
Fig. 5A is a cross-sectional view illustrating a state in which via holes are formed in the photosensitive insulating resin layer, which is a modified example of Fig. 4D.
Fig. 5B is a cross-sectional view illustrating a state in which wiring trenches are formed in the photosensitive insulating resin layer after the via holes are formed in the photosensitive insulating resin layer, which is a modified example of Fig. 4D.
Fig. 5C is a cross-sectional view illustrating a state in which an electrolytic copper plating layer is formed after the via holes and the wiring trenches are formed in the photosensitive insulating resin layer.
Fig. 5D is an enlarged detailed diagram of an enclosed region A-A' shown in Fig. 5C.
Fig. 6A is a cross-sectional view illustrating a state in which a connection terminal layer is formed by polishing the electrolytic copper plating layer.
Fig. 6B is an enlarged detailed diagram of an enclosed region A-A' shown in Fig. 6A.
Fig. 6C is a cross-sectional view illustrating a state in which fine multilayer wiring layers for mounting and connecting semiconductor devices are formed.
Fig. 6D is an enlarged detailed diagram of an enclosed region A-A' in Fig. 6C.
Fig. 7A is a cross-sectional view illustrating a state in which a non-photosensitive insulating resin layer, that is a first layer, is formed on the fine multiplayer wiring layers.
Fig. 7B is a cross-sectional view illustrating a state in which via holes are formed in the non-photosensitive insulating resin layer, that is, in the first layer.
Fig. 7C is a cross-sectional view illustrating a state in which a seed metal layer is formed on the non-photosensitive insulating resin layer, that is, the first layer.
Fig. 8A is a cross-sectional view illustrating a state in which a photoresist layer is formed on the non-photosensitive insulating resin layer, that is the first layer, provided with the via holes and the seed metal layer.
Fig. 8B is a cross-sectional view illustrating a state in which a resist pattern is formed in both the non-photosensitive insulating resin layer and the photoresist layer.
Fig. 8C is a cross-sectional view illustrating a state in which an electrolytic copper plating layer is formed on the resist pattern.
Fig. 9A is a diagram illustrating a state in which a second conductor circuit in the first layer is formed by a semi-additive method.
Fig. 9B is a cross-sectional view illustrating a state in which a non-photosensitive insulating resin layer, that is a second layer, is formed on the second conductor circuit.
Fig. 9C is a cross-sectional view illustrating a state in which via holes are formed in the non-photosensitive insulating resin layer, that is the second layer.
Fig. 10A is a cross-sectional view illustrating a state in which a seed metal layer is formed on the non-photosensitive insulating resin layer, that is the second layer.
Fig. 10B is a cross-sectional view illustrating a state in which a second conductor circuit is formed on the non-photosensitive insulating resin layer, that is the second layer, by the semi-additive method.
Fig. 11A is a cross-sectional view illustrating a state in which, on a second major surface, a second wiring layer is formed and solder resist is formed.
Fig. 11B is a cross-sectional view illustrating a state in which a glass support body is peeled off to expose a connection terminal layer for a semiconductor device.
Fig. 12 is a cross-sectional view illustrating a state in which solder bumps are formed on the connection terminal layer for the semiconductor device and a printed wiring board.

### [Description of Embodiments]

With reference to the drawings, an embodiment according to the present invention will be described. In the following description of the drawings, components identical with or similar to each other are given the same or similar reference signs. It should be noted that the drawings are only schematically illustrated, and thus the relationship between thickness and planar dimensions of the components, the thickness ratio between the layers, and the like are not to scale. Accordingly, the specific thickness and dimensions should be understood referring to the following description. As a matter of course, dimensional relationships or ratios may be different between the drawings.

The embodiment described below only exemplifies a device or a method embodying the technical idea of the present invention. The technical idea of the present invention should not limit the materials, shapes, structures, layouts, and the like of the components to those described below. The technical idea of the present invention can be modified in various ways within the technical scope defined by the claims.

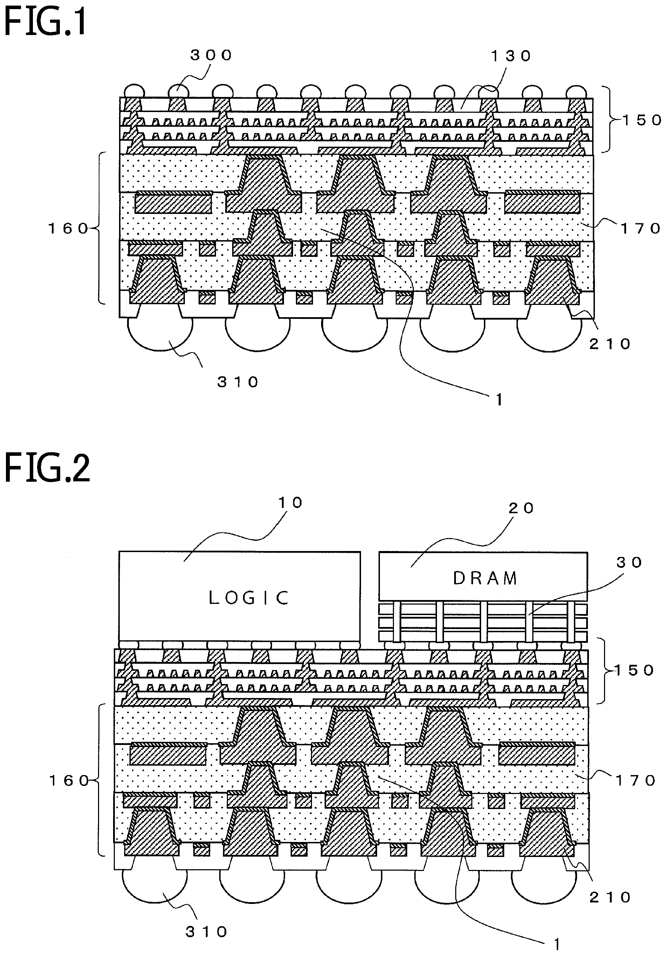

Fig. 1 illustrates a semiconductor packaging substrate 1 according to an embodiment (present embodiment) of the present invention. The semiconductor packaging substrate 1 includes connection solder bumps 300 for a semiconductor device that are formed on a first major surface on which the semiconductor device is mounted, and a second major surface on which solder bumps 310 for electrical connection to a printed wiring board are formed. The semiconductor packaging substrate 1 includes a plurality of first wiring layers 150 formed on the first major surface side, and a plurality of second wiring layers 160 on the second major surface side.

Additionally, Fig. 2 illustrates a state in which a semiconductor device 10 is connected to the first wiring layers 150 in the semiconductor packaging substrate 1 and in which a three-dimensional laminated semiconductor device 20 is connected to the first wiring layer 150 via through silicon vias (TSVs) 30.

Next, a method for manufacturing the semiconductor packaging substrate 1 will be described with reference to Fig. 1 and Figs. 3A to 12.

As a support body used to manufacture the semiconductor packaging substrate 1 in the present invention, glass is selected because it can have high planarity and rigidity, inexpensive availability of a large square panel, easy preparation of a desired thickness, and high laser light transparency which is required for laser irradiation for peeling of a support body used in a subsequent step.

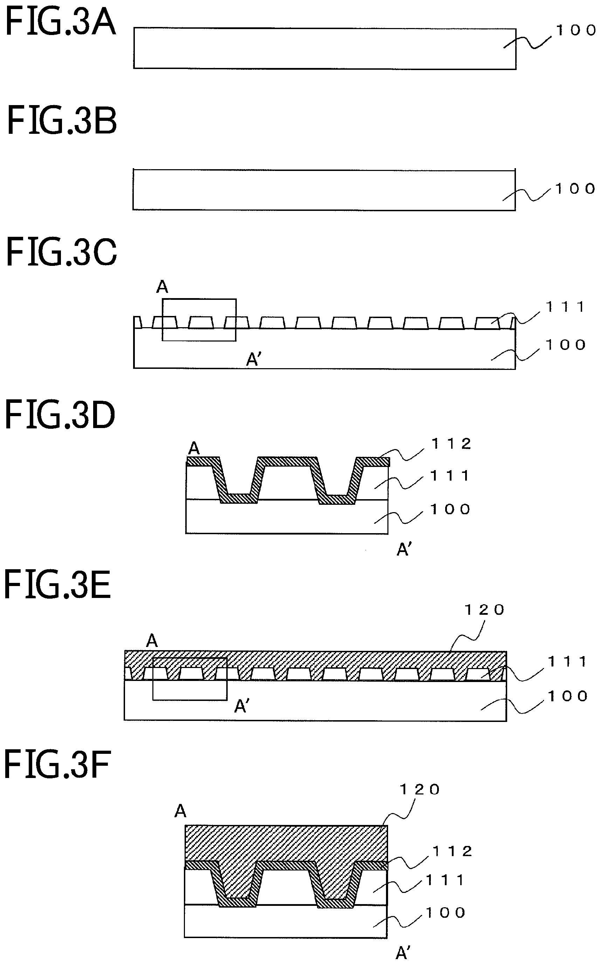

First, Fig. 3A illustrates a step of preparing a glass support body 100. Although not illustrated in the drawings, a peelable adhesive layer is formed on one surface of the glass support body 100. The adhesive layer as used herein has a function to allow final peeling and separation of the glass support body and the semiconductor packaging substrate formed on the support body, while bonding and holding a multilayer circuit during manufacturing steps.

The adhesive layer may for example use a glass wafer support system used in a wafer thinning step, which is applied in a known semiconductor device. Specifically, these well-known methods use a photolytic adhesive layer, and irradiation with light via the glass support body 100 allows the semiconductor packaging substrate and the glass support body 100 to be separated and peeled off from each other. By using laser irradiation to subject the adhesive layer to photodegradation, peeling can be easily achieved with no physical force applied. Thus, this technique prevents possible physical damage to the semiconductor packaging substrate and is thus desirable.

Examples of the glass support body 100 include a quartz glass, borosilicate glass, non-alkali glass, soda glass, sapphire glass, and the like. The thickness of the glass support body 100 is not limited. However, a thickness of 0.3 mm or more and 5 mm or less is desirable due to handleability in the manufacturing steps. A thickness of 0.7 mm or more and 3 mm or less is more desirable.

The adhesive layer formed on the glass support body 100 can be selected from, for example, an epoxy resin, a polyimide resin, a polyurethane resin, a silicone resin, a polyester resin, an oxetane resin, a maleimide resin, and an acrylic resin. As the adhesive layer, one of these resins or a resin obtained by mixing two or more of the resins may be used. The adhesive layer may further contain a photodegradation promoter or a light absorber, a sensitizer, or an additive such as a filler. Furthermore, the adhesive layer may include a plurality of layers. For example, a protective layer may further be provided on the adhesive layer in order to protect multilayer wiring layers formed on the glass support body. Moreover, a laser light reflection layer or a metal layer may be provided between the protective layer and the multilayer wiring layers, although the present embodiment is not limited to these.

Subsequently, as illustrated in Fig. 3B, a photosensitive insulating resin layer (first insulating resin layer described in the present embodiment) 110 used for a connection terminal to the semiconductor device is formed on the glass support body 100. The photosensitive insulating resin layer 110 is selected from a photosensitive polyimide resin, a photosensitive benzocyclobutene resin, a photosensitive epoxy resin, and derivatives thereof.

The photosensitive insulating resin layer 110 is selected from certain photosensitive insulating resins, and any photosensitive insulating resin may be used as long as the photosensitive insulating resin can ensure resolution and insulation. The photosensitive insulating resin may be a film or a liquid. The photosensitive insulating resin may contain a filler. However, microcircuits need to be formed and the filler may reduce resolution. Thus, it is desirable that the resin contains no filler.

For a method of forming the photosensitive insulating resin layer 110, in the case where the photosensitive insulating resin layer 110 is a film-like resin, a vacuum lamination method or a vacuum pressing method may be applied. For a liquid resin, the forming method may be selected from slit coating, curtain coating, die coating, spray coating, electrostatic coating, inkjet coating, gravure coating, screen printing, gravure offset printing, spin coating, and doctor coating. The method for forming the insulating resin is not limited by the present invention. The photosensitive insulating resin layer 110 for an external connection terminal desirably has a thickness of 5 µm or more and 30 µm or less. A thickness of 5 µm or less leads to an excessively thin external connection terminal being formed later and causes copper to disperse into the solder when the semiconductor device is soldered, hindering reliable connection. In the case where the photosensitive insulating resin layer 110 has a thickness of 30 µm or more, it is difficult to form terminals of the semiconductor device at a pitch of 40 µm or more and 60 µm or less.

A subsequent step is illustrated in Fig. 3C and Fig. 3D which is a detailed enlarged view of an enclosed region A-A' in Fig. 3C. As illustrated in Fig. 3C, first, an external connection terminal pattern 111 is formed in the photosensitive insulating resin by photolithography. According to the present embodiment, the external connection terminal pattern 111 becomes a semiconductor device mounting surface. According to the present embodiment, the semiconductor device mounting surface is formed on the planar glass support body 100, and thus a semiconductor device having high planarity can be appropriately mounted. The external connection terminal pattern 111 has a terminal pitch of 40 µm or more and 60 µm or less. Subsequently, as illustrated in Fig. 3D which is a detailed enlarged view of an enclosed region A-A' shown in Fig. 3C, a seed metal layer 112 is formed all over the external connection terminal pattern 111 which is formed of the photosensitive insulating resin. The seed metal layer of the present embodiment can be selected from Ti, Ni, Cr, Co, and Ta. For these metals, vapor deposition, CVD, or sputtering may be selected. Alternatively, for electroless plating, electroless Ni plating may be used. According to the present embodiment, it has been found that the metals listed above allow effective suppression of copper migration in spite of having a fine pattern, enabling formation of multilayer wiring having high insulation reliability. Furthermore, these metals have good adhesion with the insulating resin. Thus, it is desirable that a metal for the seed metal layer is selected from these metals. One or more layers of the metal may be used. Moreover, these chemical elements may be mixed together.

Subsequently, as illustrated in Fig. 3E and Fig. 3F which is a detailed enlarged view of an enclosed region A-A' in Fig. 3E, an electrolytic copper plating layer 120 is formed on the external connection terminal pattern 111 provided with the seed metal layer 112. The electrolytic copper plating layer 120 can be formed by a known electrolytic copper plating method. The present embodiment does not intend to limit the thickness of the electrolytic copper plating. However, the electrolytic copper plating is desirably finished with a film thickness equal to or larger than the film thickness of the connection terminal pattern 111 formed, and the film thickness is preferably 10 µm or more and 60 µm or less.

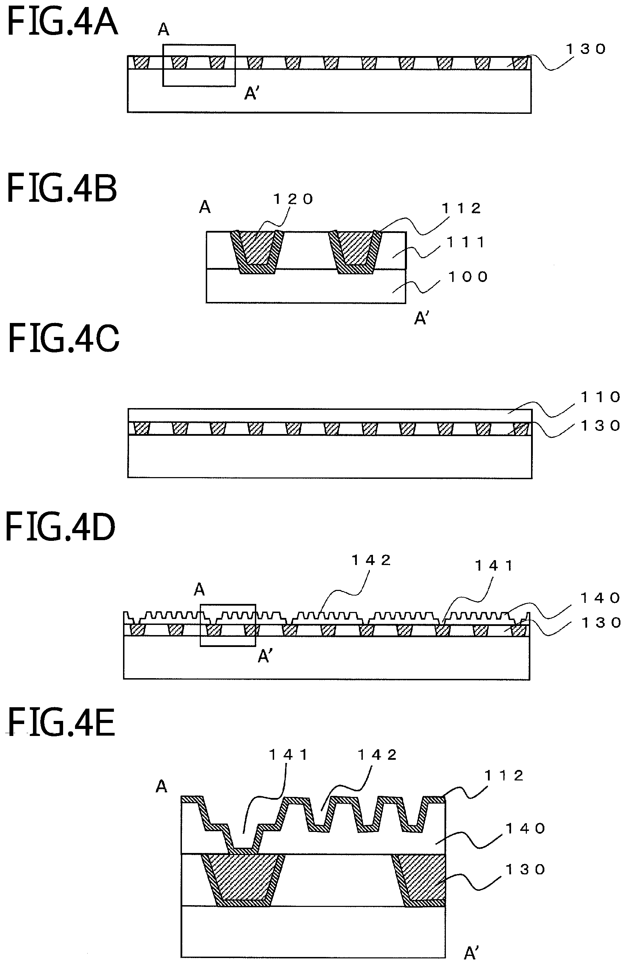

Subsequently, as illustrated in Fig. 4A and Fig. 4B which is a detailed enlarged view of an enclosed region A-A' shown in Fig. 4A, the substrate provided with the electrolytic copper plating layer 120 is subjected to cutting or CMP to remove the excess electroplating layer 120 and seed metal layer 112, and pad patterns are separated to obtain a connection terminal layer (first conductor circuit layer described in the present invention) 130 for the semiconductor device provided with a copper pad layer. For the cutting or CMP, a well-known method can be used. Such methods may be used independently or in combination, or these processing methods may be combined with wet etching. The connection terminal layer 130 desirably has a thickness of 5 µm or more and 30 µm or less. A thickness of 5 µm or less leads to an excessively thin external connection terminal being formed later and causes copper to disperse into the solder when the semiconductor device is soldered, hindering reliable connection. In the case where the photosensitive insulating resin layer 110 has a thickness of 30 µm or more, it is difficult to form terminals of the semiconductor device at a pitch of 40 µm or more and 60 µm or less.

Subsequently, as illustrated in Fig. 4C, a photosensitive insulating resin layer 110 used for wiring layer formation is formed on the substrate provided with the connection terminal layer 130 for connection to the semiconductor device. The type of the photosensitive insulating resin may be one of the well-known types described above. The photosensitive insulating resins used for wiring layer formation and for external connection terminal formation may be of the same or different in type. The well-known methods described above can also be used as a method for forming the photosensitive insulating resin layer used for wiring layer formation. The photosensitive insulating resin layer 110 for an external connection terminal desirably has a thickness of 1 µm or more and 10 µm or less. A thickness of 1 µm or less is excessively thin, and cannot ensure interlayer insulation. A thickness of 10 µm or more prevents formation of fine wiring having L/S = 5/5 µm or less.

Subsequently, as illustrated in Fig. 4D and Fig. 4E which is a detailed enlarged view of an enclosed region A-A' in shown Fig. 4D, an insulating resin pattern 140 can be formed that is provided with via hole portions 141 and wiring portions 142 by patterning using photolithography. As illustrated in Fig. 4D, a method for forming the via hole portions and the wiring portions may be a method for collectively forming via holes 141 penetrating the insulating resin and the wiring portions 142 not penetrating the insulating resin. As an example, for a positive photosensitive insulating resin, first a photomask provided with a via pattern is used to expose the via holes at an amount of exposure enabling 100% development and removal, and then exposing the wiring pattern at an amount of exposure enabling development and removal with a 50% residual film amount (or exposure of the via pattern follows wiring patterning) followed by batch development and removal. As another example, the via hole portions may be collectively exposed and developed using a gray tone mask with a transmittance enabling 100% development and removal and adjusted to provide an exposure amount corresponding to a 50% residual film amount. However, a well-known method can be used to form the via hole portions 142 and the wiring portions 141. The photosensitive insulating resin pattern 140 desirably has a thickness of 1 µm or more and 10 µm or less. A thickness of 1 µm or less is excessively thin, and cannot ensure interlayer insulation. A thickness of 10 µm or more prevents formation of fine wiring having L/S = 5/5 µm or less. The via holes formed have a diameter of 5 µm or more and 20 µm or less. A diameter of 5 µm or less leads to difficulty in maintaining connection reliability. A diameter of 20 µm or more hinders an increase in the density of wiring. Subsequently, as in the detailed enlarged view illustrated in Fig. 4E, a seed metal layer 112 is formed all over the photosensitive insulating resin pattern 140. The seed metal layer of the present embodiment can be selected from Ti, Ni, Cr, Co, and Ta. For these metals, vapor deposition, CVD, or sputtering may be selected. Alternatively, for electroless plating, electroless Ni plating may be used. According to the present embodiment, selecting the metals listed above allows suppression of copper migration in spite of having a fine pattern, enabling formation of multilayer wiring having high insulation reliability. Furthermore, these metals have good adhesion with the insulating resin. Thus, it is desirable that a metal for the seed metal layer is selected from these metals. One or more layers of the metals may be used. Moreover, these chemical elements may be mixed together.

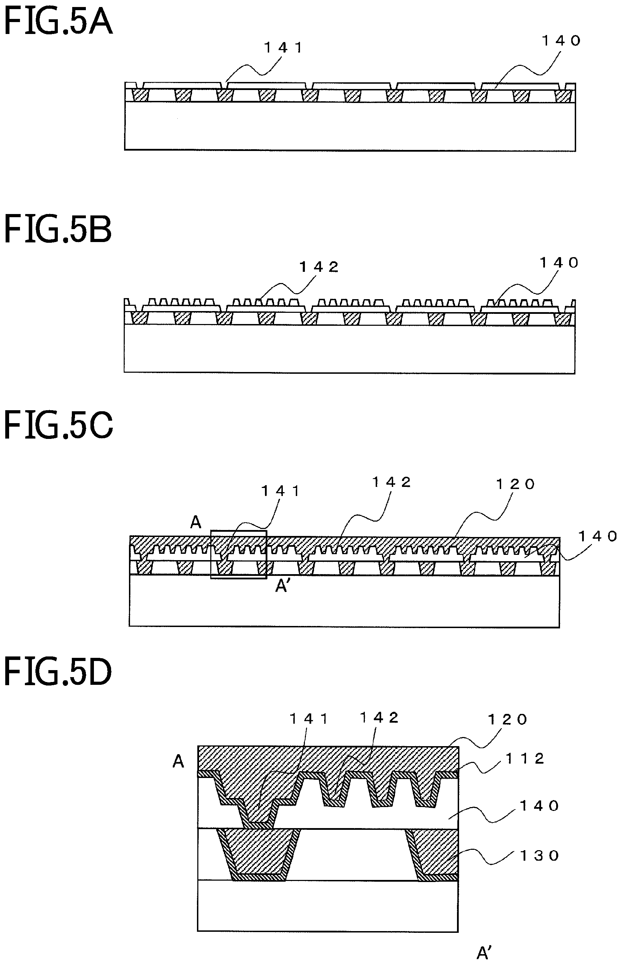

Fig. 5A and Fig. 5B illustrate a method for forming the via holes 141 and the wiring portions 142 which are different from the method shown in Fig. 4D. In this method, first, as illustrated in Fig. 5A, the insulating resin layer pattern 140 is formed with half the thickness of the one described above, and the via pattern is formed by photolithography. Then, as illustrated in Fig. 5B, the photosensitive insulating resin layer used for the wiring portions 142 is formed with a desired thickness, and wiring portions are formed by photolithography. However, the present invention intends no such limitation. The photosensitive insulating resin pattern 140 as a whole desirably has a thickness of 1 µm or more and 10 µm or less. A thickness of 1 µm or less is excessively thin, and cannot ensure interlayer insulation. A thickness of 10 µm or more prevents formation of fine wiring having L/S = 5/5 µm or less. The via holes formed have a via diameter of 5 µm or more and 20 µm or less. A via diameter of 5 µm or less leads to difficulty in maintaining connection reliability. A via diameter of 20 µm or more hinders an increase in the density of wiring.

Subsequently, as illustrated in Fig. 5C and Fig. 5D which is a detailed enlarged view of an enclosed region A-A' shown in Fig. 5C, the electrolytic copper plating layer 120 is formed using the formed seed metal layer 112 as a conductive layer. The thickness of the electrolytic copper plating layer 120 may be such that the via holes 141 and the trenches 142 can be filled with plating, and is desirably 5 µm or more and 20 µm or less. A thickness of 5 µm or less is excessively thin and prevents filling of copper plating to the vias and the trenches. A thickness of 20 µm or more requires much time to remove excess copper in the subsequent polishing planarization step.

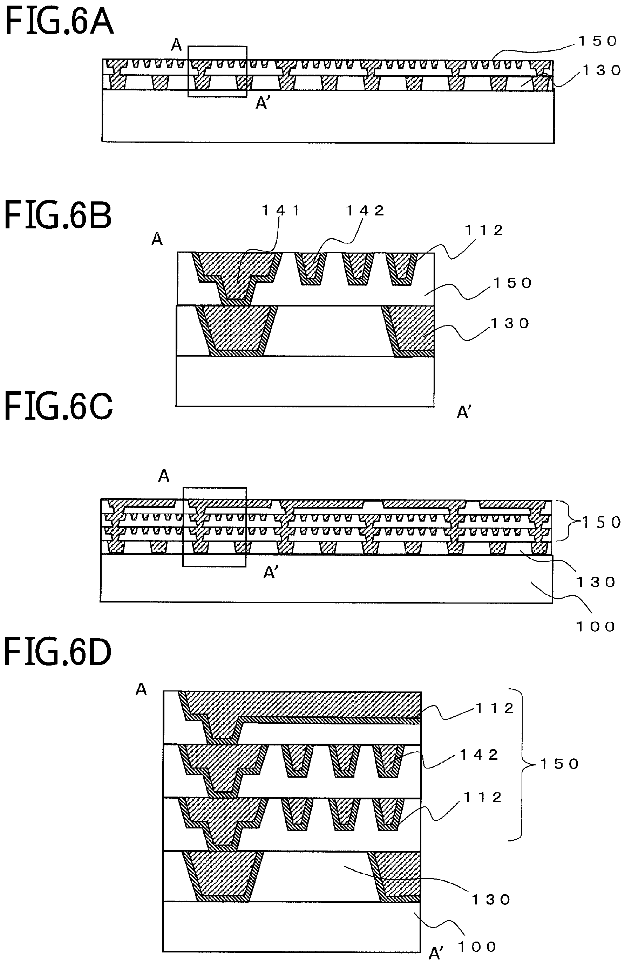

Subsequently, as illustrated in Fig. 6A and Fig. 6B which is a detailed enlarged view of an enclosed region A-A' shown in Fig. 6A, the substrate provided with the electroplating layer 120 is subjected to cutting or CMP to obtain a first wiring layer 150 provided with the wiring trenches 142 and the via holes 141. For the cutting or CMP, a well-known method can be used. These methods may be used independently or in combination, or may be combined with wet etching. The first wiring layer 150 desirably has a thickness of 1 µm or more and 10 µm or less. A thickness of 1 µm or less is excessively thin, and cannot ensure interlayer insulation. A thickness of 10 µm or more prevents formation of fine wiring having L/S = 5/5 µm or less.

Subsequently, as illustrated in Fig. 6C and Fig. 6D which is a detailed enlarged view of an enclosed region A-A' in Fig. 6C, the wiring layer formation according to the present embodiment is repeated twice to form a connection terminal layer 130 for connecting to one layer of the semiconductor device and a first wiring layer 150 having three layers of the photosensitive insulating resin.

In a well-known technique for manufacturing a semiconductor packaging substrate, a variance of dozen µm to several dozen µm or more occurs depending on the density of a glass cloth, a lower-layer copper wiring pattern, or a variance in copper thickness, leading to insufficient planarity. In the case where fine wiring is formed on such an organic substrate, it is difficult to set the planarity in an exposure area within the depth of focus of an exposure machine, leading to difficulty in manufacturing fine wiring with L/S = 5/5 µm or less at high yield.

According to the present embodiment, the first wiring layer 150 which is a fine multilayer wiring layer in which semiconductor devices are mounted and connected is formed on the glass support body 100 for which planarity can be ensured. This enables exposure within the depth of focus, allowing suppression of poor resolution caused by defocusing and enabling manufacturing at a high yield.

In a wiring forming method based on the semi-additive technique, which is a well-known method, a photoresist pattern is formed on a seed metal layer, and then a wiring pattern is formed by electrolytic copper plating. In the wiring forming method, electroplating necessarily involves current concentration and dispersion associated with a difference in pattern density. This leads to a larger plating thickness in a lower density portion and a smaller plating thickness in a higher density portion, and the method includes a variance in plating thickness corresponding to approximately 20 to 50% of the wiring thickness. Consequently, the well-known semi-additive technique involves a significant variance in circuit height, and in the case where multiple layers of microcircuits with L/S = 5/5 µm or less are formed, it is difficult to maintain a uniform insulating resin thickness between multiple layers of wiring. Thus, the insulating resin is locally thinner, leading to difficulty in ensuring the reliability of insulation between the multilayer circuit layers.

According to the present embodiment, wiring is formed such that planarization polishing is performed each time one first wiring layer 150 is formed. Thus, the wiring layer thickness can be kept constant, enabling manufacture of multilayer circuits with high planarity and reliability.

Additionally, in the wiring formation based on the semi-additive technique, which is a well-known method, photoresist is used to form a wiring pattern on the insulating resin formed into a plane. Thus, the wiring pattern is formed protruding from the insulating resin plane like protrusions. Consequently, peeling of the wiring results from physical stress (transport stress or scratch) or a decrease in wiring installation area caused by undercutting associated with etching of the seed metal layer. In particular, for fine wiring with L/S = 5/5 µm or less, wiring peeling is a serious problem.

The present embodiment provides an embedded wiring structure in which after the via holes 141 and the wiring trenches 142 are formed in the photosensitive insulating resin layer 110, the seed metal layer is formed and the via holes 141 and the wiring trenches 142 are filled with electrolytic copper plating, as illustrated in Fig. 6C and Fig. 6D. Thus, even fine wiring having L/S = 5/5 µm or less can effectively avoid the wiring peeling problem in the prior art, allowing fine multilayer wiring to be formed at a high yield. Accordingly, the wiring portions 142 of the first wiring layer 150 formed by the photosensitive insulating resin of the present embodiment, three surfaces of a bottom surface and both side surfaces are enclosed by the seed metal layer, as illustrated in Fig. 6D. The seed metal layer of the present embodiment can be selected from Ti, Ni, Cr, Co, and Ta. For these metals, vapor deposition, CVD, or sputtering may be selected. Alternatively, for electroless plating, electroless Ni plating may be used.

According to the present embodiment, the metals listed above allow effective suppression of copper migration in spite of having a fine pattern, enabling formation of the first wiring layer 150 which is a fine multilayer wiring layers having high insulation reliability. Furthermore, high adhesion to the insulating resin allows manufacturing at a high yield. One or more layers of the metal may be used. Moreover, these chemical elements may be mixed together.

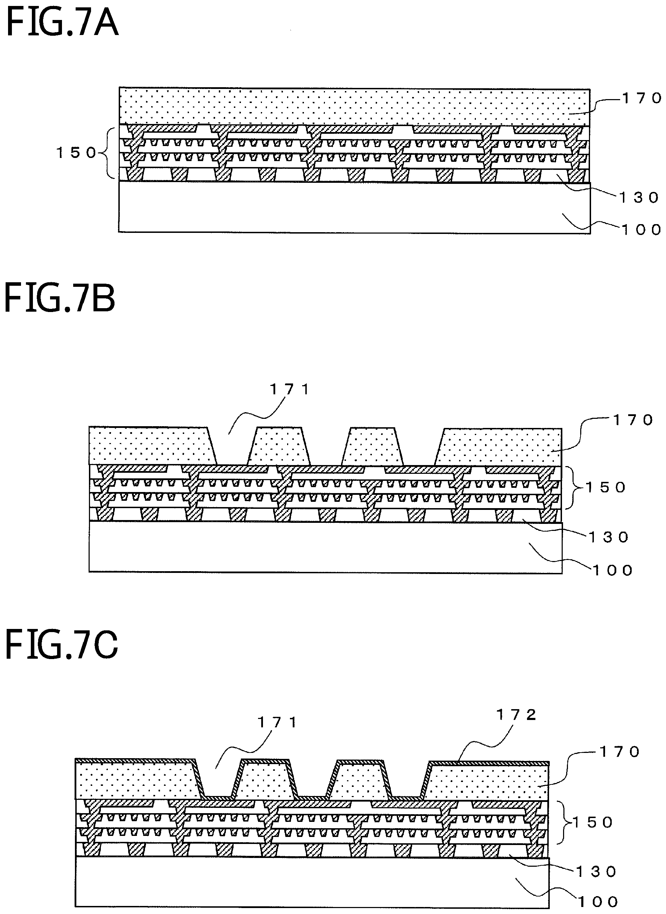

Fig. 7A is a schematic diagram illustrating that a non-photosensitive insulating resin layer (second insulating resin layer described in the present invention) 170 including a glass fiber cloth and an inorganic filler is formed on the first wiring layer 150 of the photosensitive insulating resin in the semiconductor packaging substrate.

With reference to Figs. 7A to 12 and Fig. 1, a process for forming a second wiring layer 160 of a non-photosensitive insulating resin will be described.

According to the present invention, as illustrated in Fig. 1, the first wiring layer 150 of the photosensitive insulating resin requires inter-chip connections, and thus fine wiring is essential for the first wiring layer 150. However, a printed wiring board connects to the second wiring layer 160, corresponding to multilayer wiring layers of the non-photosensitive insulating resin, and thus a lower wiring density and a larger wiring sectional area are more convenient in view of dimensional stability, and power supply and ground supply stability. For a wiring forming method of the non-photosensitive insulating resin layer, the wiring forming method based on the semi-additive technique is simple and suitable.

The non-photosensitive insulating resin layer 170 including a glass fiber cloth or an inorganic filler as illustrated in Figs. 7A to 12 and Figs. 1 and 2 can be selected from well-known prepregs and built-up resins. The non-photosensitive insulating resin layer 170 including the glass fiber cloth or the inorganic filler can function as a reinforcing layer for the thin and fine first wiring layer. Even after the glass support body is peeled off and removed, planarity can be maintained. The non-photosensitive insulating resin layer 170 including the glass fiber cloth or the inorganic filler desirably has a thickness of 20 µm or more and 200 µm or less. A thickness of 20 µm or less leads to difficulty in maintaining the rigidity of the semiconductor packaging substrate as a whole after peeling of the glass support body. If a thickness is 200 µm or more, it becomes more difficult to form holes by laser processing.

Next, a cross-sectional view shown in Fig. 7B illustrates via holes 171 being formed, by a well-known method, in the non-photosensitive insulating resin layer 170 including the glass fiber cloth or the inorganic filler. As a via forming method, laser processing is desirable in view of simplicity. A carbon dioxide laser or ultraviolet laser may be selected. The presence of a glass fiber cloth leads to high workability, and thus in this case, a CO2 laser is desirable. In the case where no glass fiber cloth is contained, a UV-YAG laser may be used. Subsequently, after the vias are formed, immersion into a permanganic acid solution (desmear treatment) is desirably used to clean the internal and peripheral portions of the vias.

Subsequently, as illustrated in Fig. 7C, a seed metal layer 172 is formed on a front surface of the non-photosensitive insulating resin layer 170 and inner walls of the via holes 171. Similarly to the photosensitive resin pattern 140, the seed metal layer may be selected from Ti, Ni, Cr, Co, and Ta. For these metals, vapor deposition, CVD, or sputtering may be selected. Alternatively, for electroless plating, electroless Ni plating may be used. One or more layers of the metal may be used. Moreover, these chemical elements may be mixed together. More preferably, electroless copper plating is desirable in view of simplicity and high adhesion. The present invention does not limit the thickness of the seed metal layer, and the thickness is desirably 0.05 µm or more and 2 µm or less. A thickness of 0.05 µm or less prevents uniform coating of electroless plating inside the vias, degrading via connection reliability as well as making subsequent filling with electrolytic copper plating difficult. A thickness of 2 µm or more extends an etching time for the subsequent removal of the seed layer and may cause even a wiring portion to be etched, leading to difficulty in finishing in accordance with the dimensions.

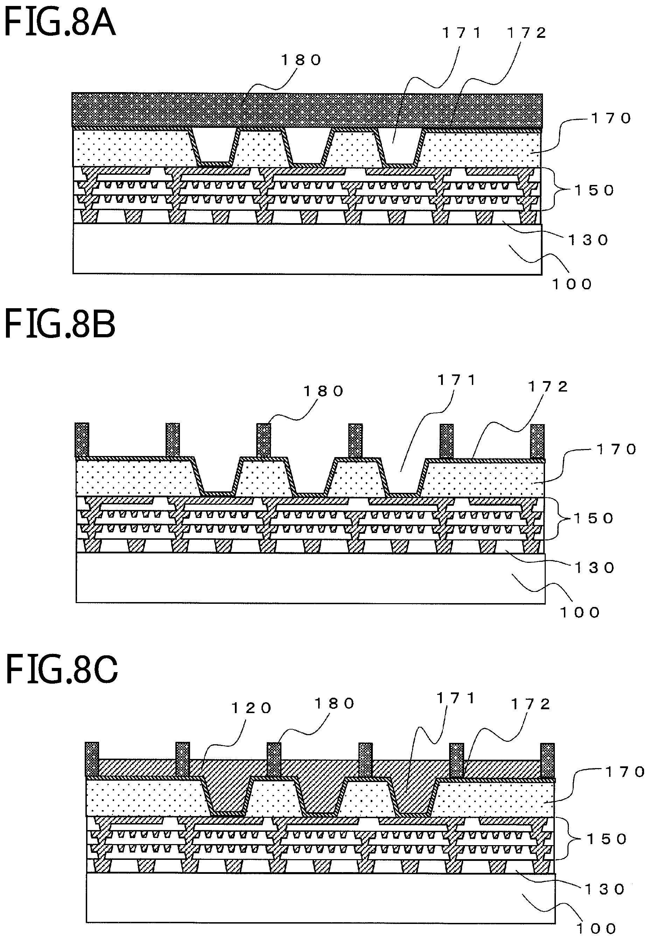

Next, a cross-sectional view shown in Fig. 8A illustrates that a photoresist layer 180 is formed on the non-photosensitive insulating resin layer 170 including the glass fiber cloth or the inorganic filler and provided with the seed metal layer. The photoresist layer is simple, and thus dry film resist is desirable. A well-known laminator can be used for a dry film resist layer forming method.

Next, a cross-sectional view shown in Fig. 8B is a diagram illustrating a state after the photoresist layer 180 being patterned. A well-known photolithography can be used for a photoresist layer patterning method.

Next, a cross-sectional view shown in Fig. 8C illustrates a state after an electrolytic copper plating layer 120 being formed. The second wiring layer 160 which is multilayer wiring layers does not need to have a high wiring density, and thus the wiring density is desirably equal to or higher than L/S = 5/5 µm or more which is the minimum pattern width. In the case where the wiring density is lower than L/S = 5/5 µm, disconnection may occur due to a difference in linear thermal expansion coefficient between the second wiring layer 160 and the printed wiring board. A plating thickness (wiring height) is desirably 5 µm or more and less than 30 µm. A plating thickness of less than 5 µm may cause disconnection as described above. A plating thickness of 30 µm or more requires much plating time, preventing efficient manufacturing.

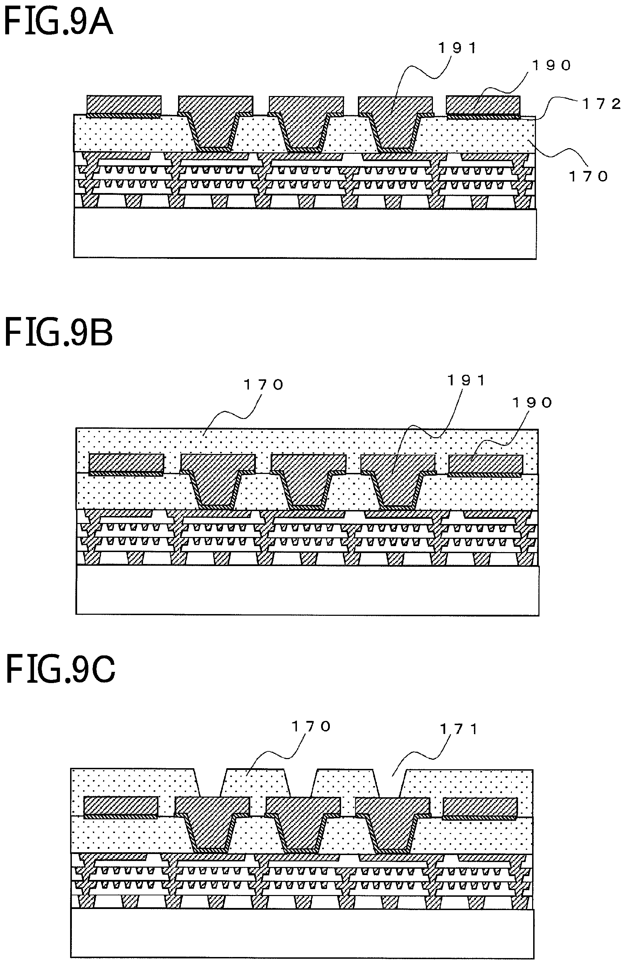

Fig. 9A is a cross-sectional schematic diagram illustrating a state after etching-away of the seed metal layer following peeling of the photoresist. Via connection portions 191 and a wiring layer 19 are formed on the non-photosensitive insulating resin layer 170 including the glass fiber cloth or the inorganic filler. The portions 191 and the layer 19 are formed using the semi-additive method. The via connection portions 191 and the wiring layer 19 form a second conductor circuit layer according to the present invention. The seed metal layer is formed on only one surface of the wiring portion 190 in the second conductor circuit layer.

Fig. 9B is a diagram illustrating that a non-photosensitive insulating resin layer 170 is formed on a second major surface of the one second circuit layer formed on the second major surface. The second major surface is a circuit for connection to the printed wiring board, and thus rather than high-density wiring, a wiring layer having a large wiring sectional area and high connection reliability is more suitable for the second major surface. Consequently, according to the present embodiment, the wiring layer thickness per layer is desirably 10 µm or more and 50 µm or less. A wiring thickness of 10 µm or less leads to difficulty in ensuring the rigidity of the semiconductor packaging substrate 1. A wiring thickness of 50 µm or more is excessively large, and thus formation of via holes becomes difficult. A non-photosensitive insulating resin layer 200 may include a well-known film like insulating resin for built-up. A method for forming the non-photosensitive insulating resin layer 200 may be general vacuum lamination.

Next, a cross-sectional view shown in Fig. 9C illustrates via holes 171 being formed in the non-photosensitive insulating resin layer 170 formed on the second major surface. The via holes 171 are desirably formed such that the via diameter of each via hole 171 is 20 µm or more and 100 µm or less. Although it is depending on the thickness of resin laminated on the second major surface, a via diameter of 20 µm or less may prevent penetration to a desired via receiving pad. A via thickness of 100 µm or more is excessively large for the subsequent electrolytic copper plating step and may prevent the vias from being filled with metal plating. Consequently, the via thickness is desirably 20 µm or more and 100 µm or less. Laser processing is desirable for a via forming method for the second major surface. A carbon dioxide laser or ultraviolet laser can be selected. Subsequently, after the vias are formed, immersion into a permanganic acid solution (desmear treatment) is desirably used to clean the internal and peripheral portions of the vias.

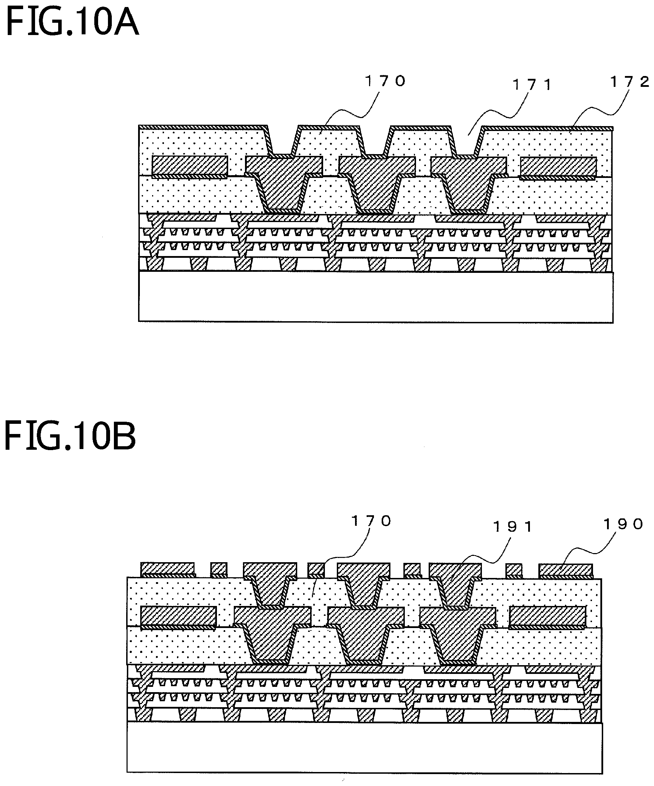

Furthermore, as illustrated in Fig. 10A, a seed metal layer 172 is formed on the front surface of the non-photosensitive insulating resin layer 170 and the via inner walls of the via holes 171. The present embodiment does not limit the type of the seed metal layer in the wiring layer of the non-photosensitive insulating resin layer. Similarly to the photosensitive insulating resin layer, Ti, Ni, Cr, Co, and Ta may be selected. For these metals, vapor deposition, CVD, or sputtering may be selected. Alternatively, for electroless plating, electroless Ni plating may be used. One or more layers of the metal may be used. Moreover, these chemical elements may be mixed together. More preferably, electroless copper plating is desirable in view of simplicity and high adhesion. The present invention does not limit the thickness of the seed metal layer, and the thickness is desirably 0.05 µm or more and 2 µm or less. A thickness of 0.05 µm or less prevents uniform coating of electroless plating inside the vias, making subsequent filling with electrolytic copper plating difficult.

The second wiring layer 160 which is a multilayer wiring layer of the non-photosensitive insulating resin according to the present embodiment, connects the printed wiring board, and thus a lower wiring density and a larger wiring sectional area are more preferable in view of dimensional stability, and power supply and ground supply stability. The present embodiment uses a wiring forming method based on the semi-additive technique.

Consequently, the seed metal layer 172 in the second wiring layer 160 which is a multilayer wiring layer, is formed on only one surface that is an installation surface of the non-photosensitive insulating resin.

Next, a cross-sectional view shown in Fig. 10B illustrates that via connection portions 191 and a wiring layer 190 are formed, by the semi-additive method, on the non-photosensitive insulating resin layer 170 formed on the second major surface. In the method of forming the wiring layer 190 using the semi-additive method, the wiring layer on the second major surface does not need to have a high wiring density. Thus, the wiring density is desirably equal to or higher than L/S = 5/5 µm or more which is the minimum pattern width. A width of 5 µm or less may cause disconnection due to a difference in linear thermal expansion coefficient between the wiring layer 190 and the printed wiring board. A plating thickness (wiring height) is desirably 5 µm or more and less than 30 µm. A plating thickness of less than 5 µm may cause disconnection as described above. A plating thickness of 30 µm or more requires much plating time, preventing efficient manufacturing.

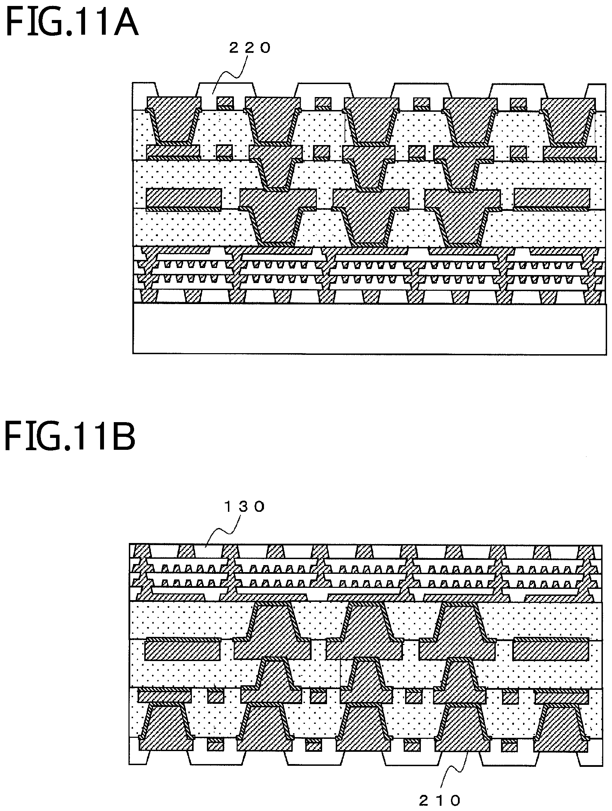

Next, a cross-sectional view shown in Fig. 11A illustrates that the method described above is repeated to form three second conductor circuit layers (via connection portions 191 and wiring layer 19) on the second major surface. The number of wiring layers in the present embodiment is not intended to limit the present invention, and can be selected from any arbitrary total number. Solder resist 220 can be formed on the second conductor circuit layer formed on the foremost second major surface. The shape of the solder resist 220 is not intended to limit the present invention.

Next, a cross-sectional view shown in Fig. 11B is a diagram illustrating the semiconductor packaging substrate being peeled off from the glass support body 100. A peeling method can be performed using a well-known substrate support system. Specifically, the glass support body 100 and the semiconductor packaging substrate are laminated to each other via the photolytic adhesive layer, and thus irradiation with laser light via the glass support body 100 allows the semiconductor packaging substrate to be peeled off and separated from the glass support body 100. After the support body is peeled off, the adhesive layer is removed by a well-known method to expose the connection terminal layer 130 for the semiconductor device and the connection terminal layer 210 for the printed wiring board.

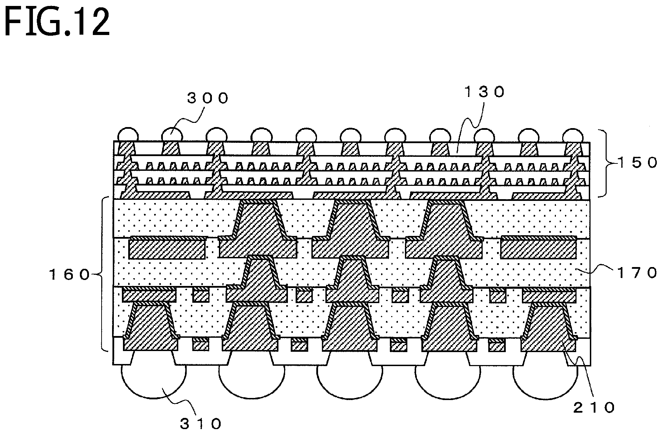

Subsequently, as illustrated in Fig. 12, solder bumps 300 are formed on exposed terminal portions of the connection terminal layer 130 in the first wiring layer 150, and solder bumps 310 are formed on exposed portions of the second conductor circuit in the second wiring layer 160. Thus, the semiconductor packaging substrate 1 illustrated in Fig. 1 is manufactured. As a solder forming method, a well-known method can be used.

According to the present embodiment, the first wiring layer 150, corresponding to fine multilayer wiring layers of the photosensitive insulating resin formed on the first major surface side, is reinforced by the non-photosensitive insulating resin layer 170 including the glass fiber cloth or the inorganic filler and the second wiring layer 160, corresponding to multilayer wiring layers of the non-photosensitive insulating resin formed on the second major surface side. Thus, even after the glass support body 100 is removed, planarity can be maintained.

Furthermore, the connection terminal layer 130 for the semiconductor device and the connection terminal for a motherboard can be simultaneously exposed, enabling electrical inspection. This allows quality assurance to be performed for the semiconductor packaging substrate 1 of the present embodiment.

In this regard, surface treatment may be performed on the terminal surface of the connection terminal layer 130 connected to the semiconductor device 10 and a three-dimensional laminated semiconductor device 29 and on the terminal surface of the connection terminal layer 210 for the printed wiring board. Possible types of the surface treatment include Ni-Au plating, Ni-Pd-Au plating, OSP, tin plating, Sn-Ag plating, and molten solder plating.

### Example 1

Next, Table 1 indicates the results of comparison tests on the seed metal layer of the first wiring layer 150 (fine multilayer wiring layer) formed of the insulating resin, formed on the first major surface according to the present embodiment. Test items include migration resistance measured based on B-HAST testing, and peel strength.

### [Method for Producing Substrate for B-HAST Testing]

An epoxy-based photosensitive insulating resin layer was formed on an 8-inch silicon wafer with a thickness of 10 µm, and then a layer of the photosensitive insulating resin was formed with a thickness of 3 µm, and an interdigitated wiring pattern having L/S = 2/2 µm was formed using photolithography. Subsequently, for sputtering, each of the seed metals listed in Table 1 and Cu were sputtered in the same batch such that the seed metal had a thickness of 50 nm, whereas a Cu layer had a thickness of 300 nm, thus forming a seed metal layer. For electroless Ni plating, the seed metal was used independently. After the seed metal layer was formed, electrolytic copper plating was applied to fill the inside of the trenches with the electrolytic copper plating. Then, CMP polishing was performed to remove excess portions of the electrolytic copper plating layer and the seed metal, thus producing an interdigitated pattern. Subsequently, the photosensitive insulating resin was formed with a thickness of 4 µm, and connection terminals for the interdigitated pattern were exposed by photolithography. The substrate with the connection terminals exposed was used for B-HAST testing.

### [Method for Producing Adhesive Strength Measuring Instrument]

Subsequently, for sputtering, each of the seed metals listed in Table 1 and Cu were sputtered in the same batch such that the seed metal had a thickness of 50 nm, and the Cu layer had a thickness of 300 nm, thus forming a seed metal layer. For electroless Ni plating, the seed metal was used independently. The seed metal layer was formed, an electrolytic copper plating layer was formed to a thickness of 25 µm, and then dry film resist was patterned to form a resist pattern with a width of 1 cm. Etching treatment was performed using a copper chloride solution to produce specimens for adhesive strength measurement. The specimens produced were subjected to 90° peel testing using a tensilon.

**[Table 1]**

| Reg | Type | Method | Formation thickness [nm] | B-HAST results (85°C, 85%, 3, 3 V, 200 h) | Adhesive strength (kgf/cm2) | Evaluation results |
|---|---|---|---|---|---|---|
| Example 1 | Ti | Sputtering | 30 | Pass | 650 | Good |
| Example 2 | Ni | Sputtering | 30 | Pass | 430 | Good |
| Example 3 | Cr | Sputtering | 30 | Pass | 600 | Good |
| Example 4 | Ni-Cr | Sputtering | 30 | Pass | 550 | Good |
| Example 5 | Co | Sputtering | 30 | Pass | 410 | Good |
| Example 6 | Ta | Sputtering | 30 | Pass | 420 | Good |
| Example 7 | Ni | Electroless | 100 | Pass | 320 | Good |
| Comparative Example 1 | Cu | Sputtering | 30 | Fail | 90 | Poor |
| Comparative Example 2 | Cu | Electroless | 100 | Fail | 50 | Good |
| Comparative Example 3 | Mn | Sputtering | 30 | Fail | 250 | Poor |
| Comparative Example 4 | Ag | Sputtering | 30 | Fail | 100 | Poor |

As indicated in the results shown in Table 1, the seed metal layers in Examples 1 to 7 were selected from Ti, Ni, Cr, Co, and Ta, and exhibited good results in B-HAST testing and adhesive strength measurement.

Metals other than the seed metals of Examples 1 to 7 and described in Comparative Examples 1 to 4 exhibited poor results in both adhesion and migration resistance.

Table 2 indicates the results of a comparison between the method for manufacturing the semiconductor packaging substrate according to Examples 8 and 9, and one according to Comparative Examples 5 and 6 of the present embodiment.

In Example 8, as in the first embodiment, by using the photosensitive insulating resin layer on the first major surface side, one connection terminal layer for the semiconductor device was formed, and three first wiring layers 150 were formed by a damascene process. The connection terminal layer 130 was formed with a thickness of 8 µm, and the wiring layer was formed with a thickness of 5 µ/m per layer. The photosensitive insulating resin layer 110 was formed such that the wiring had L/S = 2/2 µm and such that the via diameter was 10 µm. Furthermore, a prepreg containing a glass fiber cloth and having a thickness of 100 µm was formed by lamination pressing, and then a via layer with a diameter of 80 µm was formed by carbon dioxide laser. Moreover, the semi-additive method was used to form a copper circuit with a thickness of 30 µm. Subsequently, a 35-µm built-up resin film was used to form two second wiring layers 160 on the second major surface using the semi-additive technique. The layer thickness per layer was 35 µm, and the minimum wiring width was L/S = 15/15 µm. Finally, Ni-Au plating was applied to the surfaces of the connection terminals, and a solder layer was formed on the connection pads.

Additionally, in Example 9, instead of the prepreg used in Example 8, a built-up insulating resin containing 70% silica filler and having a thickness of 50 µm was used to form two wiring layers, and a semiconductor packaging substrate was formed similarly to Example 8.

Comparative Example 5 demonstrates multilayer wiring layers formed of the photosensitive insulating resin formed by a damascene process, instead of the multilayer wiring layers formed by the semi-additive technique using the built-up resin film formed on the second major surface as described in Example 8. In this example, in the photosensitive insulating resin layer formed on the second major surface, the wiring had L/S = 2/2 µm, the via diameter was 10 µm, and the wiring layer thickness was 5 µm per layer.

Comparative Example 6 demonstrates the semi-additive technique, instead of the damascene process used in Example 8 for the photosensitive insulating resin formed on the first major surface. As is the case with Example 8, the photosensitive insulating resin layer was formed such that L/S = 2/2 µm and such that the via diameter was 15 µm. In the example, the photosensitive insulating resin layer was formed such that the wiring had L/S = 2/2 µm, the via diameter was 15 µm, and the wiring layer thickness was 5 µm per layer.

**[Table 2]**

| | Example 8 | Example 9 | Comparative Example 5 | Comparative Example 6 |
|---|---|---|---|---|
| Production yield | 95% | 80% | 94% | 5% |
| Warpage amount (µm) | -7.5 | -9.1 | -8.3 | -13.1 |
| Primary mounting evaluation acceptance rate | 99% | 80% | 80% | - |
| Secondary mounting evaluation acceptance rate | 98% | 80% | 0% | - |

As shown in Table 2, in Examples 8 and 9, the semiconductor packaging substrate was successfully manufactured at a high production yield and was subjected to only a small warpage of 10 µm or less. Semiconductor TEG chip mounting was performed as primary mounting evaluation, and Examples 8 and 9 exhibited good results. As secondary mounting evaluation, for the yield at which the substrate on which primary mounting had been performed was mounted on a printed wiring board, Examples 8 and 9 exhibited good results.

On the other hand, the warpage amount and the results of the primary mounting evaluation in Comparative Example 5 were equivalent to the warpage amount and the results of the primary mounting evaluation in Example 8 and exhibited good results. However, the result of the secondary mounting evaluation was 0%. The results of failure analysis indicated that result of the secondary mounting evaluation was due to disconnection in the via portion in the wiring layer on the second major surface. Additionally, in electrical inspection, Comparative Example 5 exhibited a poor result, that is, a yield of 5%. The main causes of the defect were frequent wiring collapses and interlayer wiring short circuiting caused by a plating variance attributed to the semi-additive technique, leading to difficulty in manufacturing at a realistic yield. Thus, evaluation followup was suspended.

The results in table 2 indicate that in the semiconductor packaging substrate 1 according to the present embodiment, the first wiring layer 150, corresponding to a thin-layer fine wiring layer (fine multilayer wiring layers) of the photosensitive insulating resin formed on the first major surface side, is reinforced by the second wiring layer 160, corresponding to multilayer wiring layers of the non-photosensitive insulating resin formed on the second major surface side. Thus, even after the glass support body 100 is removed, planarity can be maintained. Consequently, a 2.1D semiconductor packaging substrate can be provided that achieves, in spite of having a thin-layer fine wiring layer, sufficient rigidity and provides high connection reliability, excellent transmission characteristics, and high insulation reliability. Also, a method for manufacturing such a 2.1D semiconductor packaging substrate can also be provided.

### [Reference Signs List]

- 1: Packaging Substrate
- 10: Semiconductor device
- 20: Three-dimensional laminated semiconductor device
- 30: TSV
- 100: Glass support body
- 110: Photosensitive insulating resin layer
- 111: External connection terminal pattern
- 112: Seed metal layer
- 120: Electrolytic copper plating layer
- 130: Connection terminal layer for semiconductor device
- 140: Insulating resin pattern
- 141: Via hole portion of first wiring layer
- 142: Wiring portion of first wiring layer
- 150: First wiring layer (fine multilayer wiring layers)
- 160: Second wiring layer (multilayer wiring layers)
- 170: Non-photosensitive insulating resin layer
- 171: Via hole
- 180: Photoresist layer
- 190: Wiring portion of second wiring layer
- 191: Via hole portion of second wiring layer
- 200: Non-photosensitive insulating resin layer
- 201: Via hole
- 220: Solder resist
- 300: Connection solder bump for semiconductor device
- 310: Connection solder bump for printed wiring substrate

## Claims

1. A semiconductor packaging substrate comprising a first major surface on which a semiconductor device is mounted, and a second major surface on which an external connection terminal for electrical connection to a printed wiring board is formed, wherein
at least one first wiring layer is formed on the first major surface side,
the first wiring layer comprises a first insulating resin layer and a first conductor circuit layer, the first conductor circuit layer comprises a via hole portion and a wiring portion, a seed metal layer is formed on three surfaces in which the first insulating resin layer and the wiring portion of the first conductor circuit layer are grounded,
at least a second wiring layer is provided on the second major surface side, and
the second wiring layer is provided with a second insulating resin layer and a second conductor circuit layer configured of a via hole portion and a wiring portion, and a seed metal layer is formed on only a surface in which the wiring portion of the second conductor circuit layer and the second insulating resin layer are grounded.

2. The semiconductor packaging substrate according to claim 1,
wherein the first insulating resin layer is formed of a photosensitive insulating resin.

3. The semiconductor packaging substrate according to claim 1 or 2, wherein
the second insulating resin layer is formed of a non-photosensitive insulating resin including at least a glass fiber cloth or an inorganic filler.

4. The semiconductor packaging substrate according to any one of claims 1 to 3,
wherein the seed metal layer formed in the first conductor circuit includes at least one metal selected from Ti, Ni, Cr, Co, and Ta.

5. The semiconductor packaging substrate according to any one of claims 1 to 4, wherein
the first wiring layer has a higher wiring density and a smaller layer thickness per layer than the second wiring layer.

6. A method for manufacturing a semiconductor packaging substrate, the method comprising the steps of:
forming, on a glass support body, a first conductor circuit layer on a first insulating resin layer formed of a photosensitive insulating resin to form at least a wiring layer;
forming, on the first wiring layer, a second insulating resin layer comprising a non-photosensitive insulating resin including a glass fiber cloth or an inorganic filler and forming, on the second insulating resin layer, a second conductor circuit layer comprising a via hole portion and a wiring portion using a semi-additive technique to form at least a second wiring layer; and
peeling a laminate of the first wiring layer and the second wiring layer from the glass support body.
